(19) Europäisches Patentamt
European Patent Office
Office européen des brevets

(11) **EP 1 563 657 B1**

(12) **EUROPEAN PATENT SPECIFICATION**

(45) Date of publication and mention
of the grant of the patent:
**14.02.2007 Bulletin 2007/07**

(51) Int Cl.:
*H04L 25/03* (2006.01)   *G06F 17/14* (2006.01)
*H03H 21/00* (2006.01)

(21) Application number: **03769770.3**

(22) Date of filing: **10.11.2003**

(86) International application number:
**PCT/IB2003/005054**

(87) International publication number:
**WO 2004/045175 (27.05.2004 Gazette 2004/22)**

(54) **TRANSFORM-DOMAIN SAMPLE-BY-SAMPLE DECISION FEEDBACK EQUALIZER**

ENTZERRER ZUR ABTASTWERTWEISEN ENTSCHEIDUNGSRUECKMELDUNG IM TRANSFORMATIONSBEREICH

EGALISEUR A DECISION RETROACTIVE ECHANTILLON PAR ECHANTILLON DU DOMAINE DE TRANSFORMATION

(84) Designated Contracting States:
**AT BE BG CH CY CZ DE DK EE ES FI FR GB GR HU IE IT LI LU MC NL PT RO SE SI SK TR**

(30) Priority: **12.11.2002 US 425847 P**
**06.02.2003 US 445390 P**

(43) Date of publication of application:
**17.08.2005 Bulletin 2005/33**

(73) Proprietor: **Koninklijke Philips Electronics N.V.**
**5621 BA Eindhoven (NL)**

(72) Inventor: **BIRRU, Dagnachew**
**Briarcliff Manor, NY 10510-8001 (US)**

(74) Representative: **Groenendaal, Antonius W. M.**
**Philips**
**Intellectual Property & Standards**
**P.O. Box 220**
**5600 AE Eindhoven (NL)**

(56) References cited:
• **GHOBRIAL A ET AL: "Discrete wavelet transform domain adaptive decision feedback equalization" PROCEEDINGS OF THE THIRTY-FOURTH SOUTHEASTERN SYMPOSIUM ON SYSTEM THEORY, 18 March 2002 (2002-03-18), pages 243-247, XP010599096 Huntsville, AL, USA**
• **MODLIN C S ET AL: "A restructred decision feedback equalizer for facilitating the LMS algorithm" SIGNALS, SYSTEMS AND COMPUTERS, 1994. 1994 CONFERENCE RECORD OF THE TWENTY-EIGHTH ASILOMAR CONFERENCE ON PACIFIC GROVE, CA, USA 31 OCT.-2 NOV. 1994, LOS ALAMITOS, CA, USA, IEEE COMPUT. SOC, US, 31 October 1994 (1994-10-31), pages 1525-1529, XP010148832 ISBN: 0-8186-6405-3**
• **GLENTIS G O ET AL: "Efficient Least Squares Adaptive Algorithms for FIR Transversal Filtering" IEEE SIGNAL PROCESSING MAGAZINE, vol. 16, no. 4, 1 June 1999 (1999-06-01), pages 13-41, XP002268696**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The present invention is directed to methods and apparatuses for processing received digital signals in a digital communications system, and more particularly to a method and apparatus for processing received digital signals in a digital communications system using packet based signals in the presence of noise and inter-symbol interference.

The invention relates to a method for performing equalization on an input signal in a receiver, the method comprising:

coupling an equalizer output signal to a decision device and receiving a receiver decision signal back from the decision device.

The invention also relates to an apparatus for receiving a digital signal comprising:

a receiver decision device for receiving an equalizer output signal and for supplying a receiver decision signal; and an adaptive equalizer for supplying the equalizer output signal and for receiving the receiver decision signal.

Adaptive equalizers are often used in digital communication systems to mitigate inter-symbol interference caused by multi-path. Among the many variants of adaptive equalizers, Least Mean Squares (LMS) type decision feedback equalizers are the most frequently used. For emerging applications where the channel is dynamic or requiring fast convergence speed, the traditional LMS-type equalizers often exhibit inadequate performance.

The convergence speed of traditional time-domain LMS type adaptive equalizers depends on the ratio of the maximum to the minimum eigenvalues of the autocorrelation matrix of the input. Filters having inputs with a wide eigenvalue spread often take longer to converge than filters with white noise inputs.

As a remedy to this problem, transform domain equalizers were developed. These equalizers are based on orthogonalization of the input signals, which are often referred to as frequency-domain adaptive filters. Such orthogonalization techniques have been used in the context of linear (FIR) adaptive filters. Simulations have shown that such equalizers have better convergence properties compared to the counterpart time-domain LMS algorithms. Unfortunately, linear equalizers perform very poorly if the channel spectrum contains dip nulls or the inverse of the channel has strong samples outside the range of the linear equalizer. As a result, they suffer from noise-enhancement or lack adequate numbers of taps. Inter symbol interference (ISI) due to multipath can be effectively rejected using non-linear equalizers, such as Decision Feedback Equalizers (DFEs).

Non-linear equalization techniques, such as Decision Feedback Equalizers, exhibit superior performance when compared on the basis of identical numbers of taps and tap-adaptation algorithms.

The inherent performance advantage of DFEs to combat severe multipath interference makes them attractive for practical channel equalization applications.
Nevertheless, DFEs are often used in conjunction with LMS-type algorithms for tap adaptations. As a result, the convergence speed of LMS type or blind equalizers is still dependent on the eigenvalue spread of the input. As an alternative, different techniques have been proposed, such as Recursive Least Squares (RLS), etc. However, implementation complexity often precludes the use of such tap adaptation algorithms in practical applications.

In the paper "Discrete wavelet transform domain adaptive decision feedback equalization" by A. Ghobrial et al., in Proceedings of the Thirty-Fourth Southeastern Symposium on System Theory, 2002, pp. 243-247, discrete wavelet transform processing is applied to the decision feedback equalization adaptation problem.

The present invention is therefore directed to the problem of developing a method and apparatus for increasing the convergence speed of a digital channel equalizer without unduly increasing the implementation complexity. The present invention solves these and other problems by providing an adaptive transform-domain decision feedback equalizer with a convergence speed that is faster than the traditional counterpart at a modest increase in computational complexity.

The method according to the invention is characterised in that the method comprises:

creating a plurality of delayed samples of the input signal via taps;
orthogonally transforming each of the plurality of delayed input samples;
weighting the plurality of orthogonally-transformed delayed input samples using a first corresponding plurality of orthogonally-transformed adaptive coefficients; and
summing the weighted plurality of orthogonally-transformed delayed input samples along with a feedback signal and outputting a result of the summing as the equalizer output signal, wherein the feedback signal is formed by:

creating a plurality of delayed samples of the receiver decision signal via taps;
orthogonally transforming each of the plurality of delayed decision samples;

weighting the plurality of orthogonally-transformed delayed decision samples using a second corresponding plurality of orthogonally-transformed adaptive coefficients; and

summing the weighted plurality of orthogonally-transformed delayed decision samples to create the feedback signal.

In the apparatus according to the invention, said adaptive equalizer includes a processor to carry out the method according to the invention.

The dependent claims define advantageous embodiments.

According to one aspect of the present invention, a method for performing equalization on an input signal in a receiver creates multiple delayed samples of the input signal and orthogonally transforms each of the delayed input samples before weighting them using orthogonally-transformed adaptive coefficients. The weighted orthogonally-transformed delayed input samples are summed along with a feedback signal and the result is output as the equalizer output signal. The feedback signal is formed from delayed samples of a receiver decision signal, which are orthogonally transformed, then weighted using orthogonally-transformed adaptive coefficients, and finally summed and fed back as the feedback signal.

An exemplary embodiment of the equalizer herein is particularly suitable for applications with small delay dispersions, such as home networks or LANs.

FIG 1 depicts a conventional receiver with an equalizer.

FIG 2 depicts a block diagram of an exemplary embodiment of an apparatus for performing a Transform-Domain Decision Feedback Equalizer (TDDFE) according to one aspect of the present invention.

FIG 3 depicts a block diagram of an exemplary embodiment of an apparatus for performing a Hybrid DFE (HDFE) according to another aspect of the present invention.

FIG 4 depicts an exemplary embodiment of a method for computing a transform of a sequence in a recursive manner according to yet another aspect of the present invention.

FIG 5 depicts a graph of simulation results of the embodiment of FIG 1 for a paper channel, $\mu_1$=20, $\mu_2$=16, LMS (factor 32), averaged over 500 symbols.

It is worthy to note that any reference herein to "one embodiment" or "an embodiment" means that a particular feature, structure, or characteristic described in connection with the embodiment is included in at least one embodiment of the invention. The appearances of the phrase "in one embodiment" in various places in the specification are not necessarily all referring to the same embodiment.

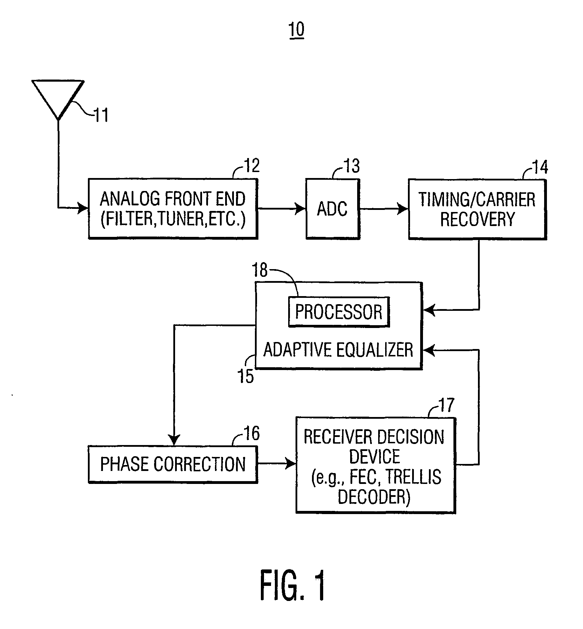

Turning to FIG 1, shown therein is an exemplary embodiment of a digital receiver 10 according to one aspect of the present invention. The receiver 10 includes an antenna 11, an analog front end (e.g., a filter, tuner, etc.) 12, and analog-to-digital converter (ADC) 13, a timing/carrier recovery circuit 14, an adaptive equalizer 15 having its own processor 18, a phase-corrector 16 and a receiver decision device (such as a forward error corrector or trellis decoder) 17. 23.

In this exemplary embodiment, the adaptive equalizer (e.g., 20, 30) is also coupled to the receiver decision device (17) and includes a processor (18) to: create delayed versions of the digital signal; orthogonally transform the delayed versions and weight them using transformed adaptive coefficients; sum the weighted and orthogonally-transformed delayed versions of the digital signal along with a feedback signal to create an equalized output signal. Moreover, the processor adaptively updates the transformed adaptive coefficients based on decisions made in the receiver decision device using prior versions of an equalized output signal. This updating is performed in the conventional manner, except that the adaptive coefficients are orthogonally transformed as set forth below.

The present invention concerns the equalization stage of a receiver. The present invention allows decision-feedback equalizers to converge faster than conventional equalizers. Fast convergence is essential in bi-directional packet based digital communications systems, such as wireless Local Area Networks (LANs). Thus, the present invention makes possible receivers that can operate in places with high levels of multipath or that can switch faster between channels/cells. The embodiments herein can be employed in any digital communications system, such as a wireless LAN, which requires channel equalization.

An exemplary embodiment of the present invention provides a transform domain decision feedback equalizer technique. Further, the description herein includes performance evaluations using simulations. The exemplary embodiment exhibits superior performance compared to the traditional LMS type DFEs. From an implementation point of view, this technique is well suited for applications requiring small numbers of taps.

The Transform-Domain DFE, termed herein TDDFE, is based on applying orthogonal transformation of the inputs of both the forward and feedback sections. The orthogonal transform can be a Fast Fourier Transform (FFT), Discrete Cosine Transform (DCT), or another similar transform. The taps of the TDDFE are updated in the inverse-transform domain using orthogonalization techniques. In order to proceed further, we revise the conventional time-domain LMS-DFE relationships:

$$\mathbf{y}(n) = \mathbf{x}(n) \cdot \mathbf{c}^T(n) + \mathbf{b}(n-1) \cdot \mathbf{f}^T(n)$$

$$e(n) = d(n) - y(n)$$

$$\mathbf{c}(n+1) = \mathbf{c}(n) + \mu e(n)\mathbf{x}(n)^*$$

$$\mathbf{f}(n+1) = \mathbf{f}(n) + \mu e(n)\mathbf{b}(n-1)^*$$

$$b(n) = dd[y(n)] \tag{1}$$

where y(n) is the output of the equalizer, x(n)={x(n), x(n+1), ..., x(n-M+1)} is a vector consisting of the samples of the equalizer input, b(n)={b(n), b(n+1), ..., b(n-N+1)} is a vector consisting of the input samples b(n) of the feedback section, c(n) is an M-length vector consisting of the coefficients of the feed-forward section of the equalizer, f(n) is an N-length vector consisting of the coefficients of the feedback section of the equalizer, d(n) is a reference signal or a locally generated decision term, e(n) is the error term, $\mu$ is the adaptation step size, dd[y(n)] is the decision device, '*' denotes complex conjugate and 'T' denotes transpose operation. We define the orthogonal transform operation in a square matrix format $T_1$ and $T_2$ where $T_1$ is an MxM square matrix and $T_2$ is an NxN square matrix. The inverse of these matrices represent the inverse transform, i.e., $\mathbf{T_1}.\mathbf{T_1^{-1}} = \mathbf{T_2}.\mathbf{T_2^{-1}} = \mathbf{I}$, where I is the identity matrix. Using this property of the matrices, equation (1) can be described as:

$$y(n) = \mathbf{x}(n)\mathbf{T_1} \cdot \mathbf{T_1^{-1}}\mathbf{c}^T(n) + \mathbf{b}(n-1)\mathbf{T_2} \cdot \mathbf{T_2^{-1}}\mathbf{f}^T(n) \tag{2}$$

Defining the transformed variables $\chi(n) = \mathbf{x}(n) \cdot \mathbf{T_1}$, $\zeta(n) = \mathbf{c}(n)\mathbf{T_1^{-1T}}$, $\beta(n) = \mathbf{b}(n)\mathbf{T_2}$, and $\nu(n) = \mathbf{f}(n)\mathbf{T_2^{-1T}}$, the above equation can be described as:

$$y(n) = \chi(n)\zeta^T(n) + \beta(n-1)\nu^T(n) \tag{3}$$

Equation (3) describes the input output relationship of the TDDFE equalizer where the output is computed using the transformed variables. By multiplying both sides of the tap-adaptation equations in (1) with the transform matrices $T_1$ and $T_2$ and considering only the transform operation where $T_2 = T_2^*$, we easily find:

$$\zeta(n+1) = \zeta(n) + \mu e(n)\chi^*(n)$$

$$\nu(n+1) = \nu(n) + \mu e(n)\beta^*(n) \tag{4}$$

The above equations are just an alternative way of describing the time-domain LMS-type equalizer in the transform domain. As a result, there is no reason to expect that the performance of this equalizer will be different from that of the time-domain counterpart. Nevertheless, these equations provide a simple means by which orthogonalization of the input can be achieved to obtain an equalizer that converges faster and exhibits better tracking behavior. Orthogonalization is achieved by measuring the average power of the transformed inputs and using these in the tap-adaptation equations (4). Defining the average values as:

$$\mathbf{\Gamma}_x(n+1) = \lambda\mathbf{\Gamma}_x(n) + |\chi(n)|^2$$

$$\mathbf{\Gamma}_b(n+1) = \lambda\mathbf{\Gamma}_b(n) + |\beta(n)|^2 \tag{5}$$

where $|\cdot|^2$ is an element-wise magnitude operator,, $\lambda$ is a positive constant,and $\Gamma_x$ (n) and $\Gamma_b$ (n) are the respective average values, the tap-update equations are then modified to:

$$\zeta(n+1) = \zeta(n) + \mu e(n)\chi^*(n)\cdot/\Gamma_x(n)$$

$$v(n+1) = v(n) + \mu e(n)\beta^*(n)\cdot/\Gamma_b(n) \qquad (6)$$

where the operation './' is an element-wise vector division. The gradient terms in (6) consist of almost uncorrelated variables due to the orthogonal transform operation. As a result, each frequency bin is weighted by variables that are not dependent on the other variables. This is similar to having a time-varying adaptation constant for each tap of the equalizer. Since the tap-adaptation is done using uncorrelated variables, it is natural to expect that the convergence speed of this equalizer is relatively insensitive to the eigenvalue spread and that it converges faster than the traditional time-domain LMS equalizer. As pointed out below, this algorithm is in fact an approximate RLS algorithm. The vectors $\Gamma_x$ and $\Gamma_b$ are the diagonal elements of the autocorrelation matrix. As a result of this type of RLS type approximation, it shares the behavior of the standard RLS algorithm, but at a reduced computational complexity.

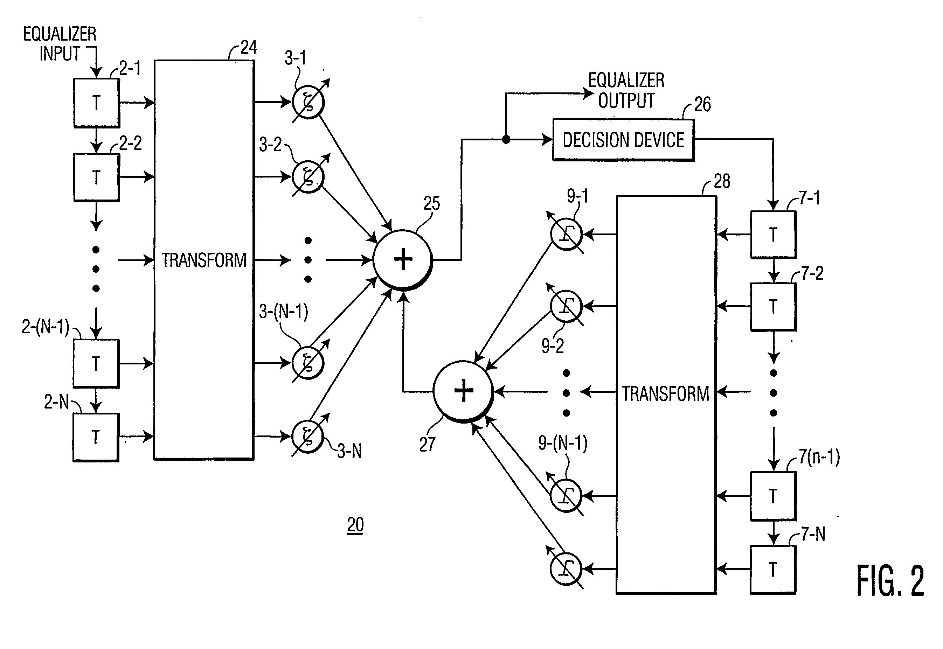

An exemplary embodiment 20 of the top-level architecture of this transform-domain DFE is shown in FIG 2. The input to the equalizer is fed into N taps 2-1 through 2-N. Each of the outputs from the taps is fed into transform 24.

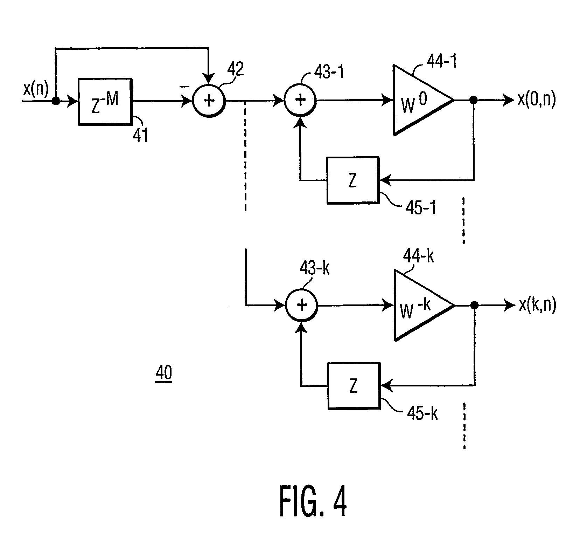

Transform 24 performs an orthogonal transform on the outputs of the taps 2-1 through 2-N. Various types of orthogonal transforms can be employed, such as a Fast Fourier Transform (FFT) or a Discrete Cosine Transform (DCT), to name only a few. FIG 4 depicts an exemplary embodiment of the transform 24.

The transform outputs, of which there are N in number, are then weighted by the $\zeta(n)$ coefficients, which are the transformed filter coefficients c(n), which are the original filter coefficients used in a conventional Decision Feedback Equalizer.

The weighted and transformed tap outputs (i.e., the inputs to summer 25) are then summed at summer 25 and the result is output to decision device 26. The output of the decision device 26 is also fed through N taps 7-1 through 7-N, the outputs of which are fed through another transform 28.

Transform 28 performs an orthogonal transform on the outputs of the taps 7-1 through 7-N, similar to that employed in transform 24. However, a different type of orthogonal transform can be employed than that used in transform 24. The transform shown in FIG 4 could also be applied as transform 28.

The outputs of the transform 28, of which there are N in number, are then weighted by the transformed filter coefficients $v(n)$, the results of which weighting are then summed at summer 27 and fed back into summer 25.. The equalizer output is then output from the summer 25 for processing by the receiver decision device 26, which outputs a receiver decision signal to taps 7-1 through 7-N as described above.

The orthogonal transform converts its input to an uncorrelated variable. As a result, faster convergence is expected if diagonalized tap adaptation is employed. However, if the input itself is uncorrelated, then there is no adequate reason to expect performance advantages of the transform domain operations. This rationale can be used to simplify the operations needed for the transform domain DFE.

Decision-Feedback Equalizers exhibit superior performance when the input samples of the feedback filter are correct, i.e., these samples equal the transmitted samples. If the decision device produces correct decisions, then the input of the feedback filter is naturally uncorrelated. This is based on the assumption that the transmitted sequence is also uncorrelated. Under these assumptions, there is no reason to expect performance advantage by operating the feedback part of the DFE in the transform domain. In order to save computation due to the transform, the feedback part can operate in the pure time-domain mode. This mode of operation is hereinafter referred to as Hybrid Decision-Feedback Equalization (HDFE). The input output and tap-update relationship of the HDFE can be described by:

$$y(n) = \chi(n)\zeta^T(n) + \mathbf{b}(n-1)\mathbf{f}^T(n)$$

$$\zeta(n+1) = \zeta(n) + \mu_1 e(n)\chi^*(n)\cdot/\Gamma_x(n)$$

$$\mathbf{f}(n+1) = \mathbf{f}(n) + \mu_2 e(n)\mathbf{b}(n-1)^* \qquad (7)$$

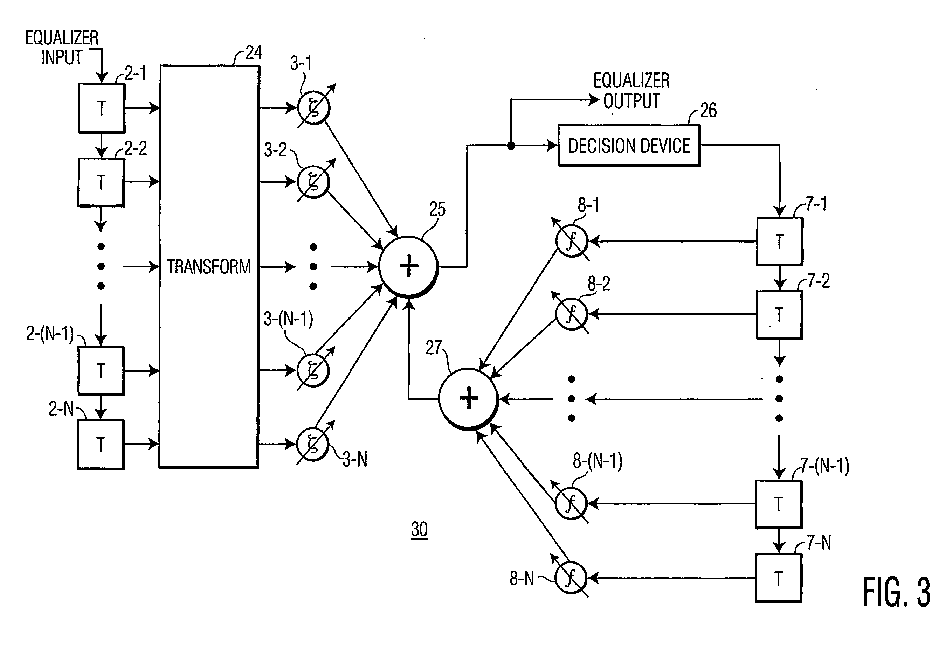

FIG 3 illustrates an exemplary embodiment 30 of the hybrid DFE scheme. The feed forward portion of the circuit 30 remains unchanged from the embodiment 20 shown in FIG 2. The input to the equalizer 30 is fed into N taps 2-1 through 2-N. Each of the outputs from the taps 2-1 through 2-N is fed into transform 24.

Transform 24 performs an orthogonal transform on the outputs of the taps 2-1 through 2-N. As in the above embodiment, various types of orthogonal transforms can be employed, such as a Fast Fourier Transform (FFT) or a Discrete Cosine Transform (DCT), to name only a few. The transform shown in FIG 4 could be employed here as well.

The transform outputs, of which there are N in number, are then weighted by the ζ(n) coefficients, which are the transformed filter coefficients c(n), which are the original filter coefficients used in a conventional Decision Feedback Equalizer.

The weighted and transformed tap outputs (i.e., the inputs to summer 25) are then summed at summer 25 and the result is output to decision device 26. The output of the decision device 26 is also fed through N taps 7-1 through 7-N. This is where the two embodiments differ.

The tap outputs, of which there are N in number, are then weighted by the feedback filter coefficients f(n), the results of which weighting are then summed at summer 27 and fed back into summer 25 as error signals. The equalizer output is then output from the summer 25 for processing by the receiver decision device 26, which outputs a receiver decision signal to taps 7-1 through 7-N as described above.

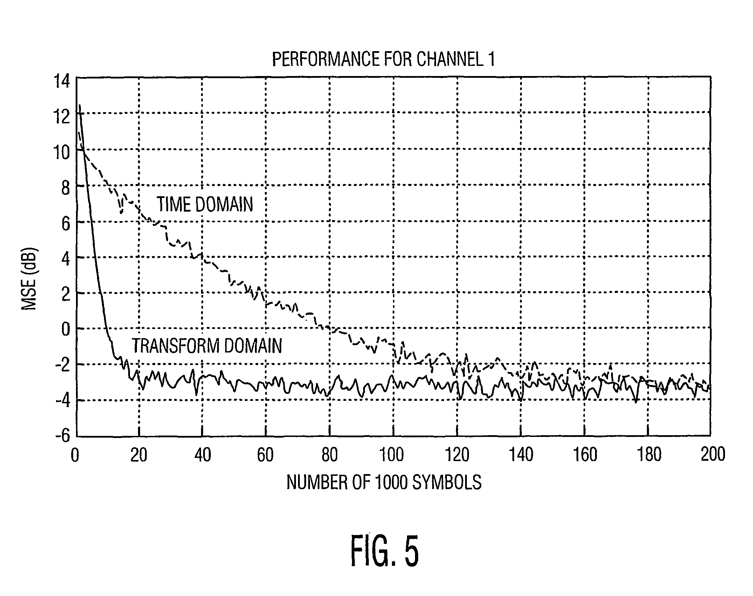

Note that the adaptation step sizes $\mu$'s for the transform domain and the time-domain tap adaptation are different. The performance of this equalizer was evaluated using simulation, the results of which are shown in FIG 5.

As mentioned earlier, the feedback decisions will not be correct if the interference (e.g., multipath and noise) is severe and if a simple slicer is used as the decision device. If the feedback decisions are not correct, the DFE will suffer performance degradation due to these incorrect decisions circulating in the feedback path. This effect is commonly referred to as error-propagation. The error propagation behavior of DFEs is well observed using simulations, but little understood analytically. Rather, researchers opted to employ techniques that reduce error propagation. These techniques are centered on the use of reliable decision devices. One common method of obtaining reliable decisions is by forming decisions from the results of the forward error correction unit.

As with other stochastic adaptive algorithms, the adaptation step size determines both the learning curve and the steady-state Mean Square Error (MSE). The adaptation step-size of the feedback filter and the forward filter can be set to different values to obtain better performance. The average values of the power estimate give adequate clues to obtain step sizes. Assuming that the step size of the forward and feedback sections of the time-domain DFE are the same, the step sizes of the TDDFE and the HDFE can be chosen, such that the average value of the step sizes equal the time-domain step size. For the DFT type transform, this procedure results in the following values of the step sizes.

$$\text{For the TDDFE:} \quad \mu_1 = pM\mu, \ \mu_2 = pN\mu \quad \text{and}$$
$$\text{For the HDFE:} \quad \mu_1 = pM\mu, \ \mu_2 = \mu.$$

where p is the average power of the time-domain input signal, and $\mu$ is the time-domain step size. The performance of the equalizer is evaluated using these step size relationships.

In order to evaluate the performance of the proposed equalizer, computer simulations were made for both the exemplary embodiment of the equalizer and the time-domain equalizer with equal numbers of taps. A 32-tap forward and a 16-tap feedback equalizer were used. The adaptation constants ($\mu$) for both equalizers were chosen such that the MSE curves of both equalizers exhibit similar convergence performance and steady-state MSE for a channel with a post echo of-6 dB at one sample away from the main path. The simulation results are plotted in FIG 3 for a paper channel, $\mu_1$=20, $\mu_2$=16, LMS (factor 32), averaged over 500 symbols. As these simulation results indicate, the transform-domain equalizer converged faster than the time-domain equalizer, confirming the expectation.

The exemplary embodiment of the transform-domain DFE requires the computation of the transform values on a sample-by-sample basis. As a result, the computational complexity of the exemplary equalizer can be higher than a conventional LMS-type time-domain DFE.

The need for the transform operation every sample precludes using the exemplary embodiment of the equalizer in applications for systems with large delay dispersion, such as terrestrial broadcast applications. Such systems in general require long filters to combat the interference effects of the channel with long delay dispersions. For such applications, a block frequency domain equalizer will be preferable to reduce the computational complexity.

However, the computational complexity of the exemplary embodiment can be reduced to such an extent that the remaining added complexity is offset by the performance advantages. The resulting equalizer is most suitable for small delay dispersion systems, such as home networks or LANs.

The computational requirement can be simplified in the following manner. First, the division by the average power can be approximated by a binary shift operation. This is achieved by approximating the values of Γ's with the nearest value that is of the form $2^k$, where k is an integer. Second, the sample-by-sample transforms can be computed by using the prior transform values in a recursive manner. In the case of a Discrete-Fourier Transform, this computation can be achieved as follows. The DFT of the sequence $x_{n-1}$ is described by:

$$X(k, n-1) = \sum_{i=0}^{M-1} x(n - M + i)W^{ik} \qquad (8)$$

Similarly, the DFT of $x_n$ is

$$X(k, n) = \sum_{i=0}^{M-1} x(n - M + 1 + i)W^{ik} \qquad (9)$$

Replacing the index 1+i with i, we obtain:

$$X(k, n) = \sum_{i=1}^{M} x(n - M + i)W^{(i-1)k} \qquad (10)$$

This equation can also be described as:

$$X(k, n) = W^{-k}\left( \sum_{i=0}^{M-1} x(n - M + i)W^{ik} - x(n - M) + x(n)W^{Mk} \right) \quad (11)$$

Since $W^{MK}=1$, and the inner summation equals X(k, n-1), we find:

$$X(k, n) = W^{-k}\big( X(k, n-1) - x(n - M) + x(n) \big) \qquad (12)$$

This equation, when applied to each frequency bin, computes the DFT of the sequence in a sample-by-sample basis using the previously computed values in a recursive manner. This form of computation, which is similar to filtering the input sequence using band pass filters, provides computational savings compared to the FFT operation when done on a sample-by-sample basis, i.e., the radix-2 FFT operation requires $M/2\log_2(M)$ complex multiplications while the exemplary embodiment equalizer requires M complex multiplications.

FIG 4 illustrates a simplified method to compute the transform of the input sequence in a recursive manner. Shown in FIG 4 is exemplary embodiment 40, in which the equalizer input x(n) is fed into filter 41, the output of which is coupled to summer 42 which is subtracted from the original input. The output of summer 42 is fed into k summers 43-1 through 43-k, the other input of which comprise the feedback error signals. The outputs of summers 43-1 through 43-k are fed into k filters 44-1 through 44-k. The outputs of filters 44-1 through 44-k represent the k values of X(k, n).

The recursive least squares method minimizes the cost function:

$$J(n) = \sum_{i=1}^{n} \lambda^{n-1} |e(i)|^2 \qquad (13)$$

where e(n) = d(n) - w(n)u(n)$^T$. The optimum value for the tap weight vector, w(n) = [c(n) f(n)], for which the cost function J(n) attains minimum value is defined by the following set of equations:

$$\Phi(n)\mathbf{w}(n) = \mathbf{z}(n) \qquad (14)$$

where the (N+M) by (N+M) correlation matrix is defined by

$$\Phi(n) = \sum_{i=1}^{n} \lambda^{n-1} \mathbf{u}(i)\mathbf{u}(i)^H$$
$$= \lambda\Phi(n-1) + \mathbf{u}(n)\mathbf{u}(n)^H \qquad (15)$$

u(n) is the combined input of the forward and feedback path, u(n)=[x(n)b(n-1)]. The (M+N) by 1 cross correlation vector z(n) between the filter inputs and the desired response d(n) is defined by:

$$\mathbf{z}(n) = \sum_{i=1}^{n} \lambda^{n-1} \mathbf{u}(i)\mathbf{d}(i)^{\bullet}$$
$$= \lambda\mathbf{z}(n-1) + \mathbf{u}(n)\mathbf{d}(n)^{\bullet} \qquad (16)$$

The recursive equation for updating the least square estimate tap weight vector is then described as:

$$\mathbf{w}(n) = \mathbf{w}(n-1) + \Phi(n)^{-1}\mathbf{u}(n)^{\bullet}\epsilon(n) \qquad (17)$$

where $\epsilon(n)$ is the a priori estimation error defined by $\epsilon(n)=d(n)-w(n-1)u(n)^T$.

Invoking the assumption that the transformed variables u(n) are uncorrelated (due to the orthogonal transform operation), it can be noticed that the auto-correlation matrix is diagonal. As a result, (17) is identical to (6) except that an adaptation step constant is used in (6).

The hybrid DFE can also be derived in a similar way. If the decision device produces correct decisions, the average values of the transform of the feedback input will be approximately equal at all transform points. As a result, the values of the elements of $\Gamma_b$ can be assumed to be equal. This simplification results in the hybrid equalizer tap-update equations.

Performance degradation due to error propagation is often reduced by using better decision devices instead of a simple decision device. In particular, a trellis coded modulated system can take advantage of the trellis decoder to obtain reliable decisions that can be fed back to the feedback path of the DFE.

Although various embodiments are specifically illustrated and described herein, it will be appreciated that modifications and variations of the invention are covered by the above teachings and are within the purview of the appended claims without departing from the intended scope of the invention. Furthermore, these examples should not be interpreted to limit the modifications and variations of the invention covered by the claims but are merely illustrative of possible variations.

**Claims**

1. A method for performing equalization on an input signal in a receiver, the method comprising:

coupling an equalizer output signal to a decision device (17) and receiving a receiver decision signal back from the decision device (17),
creating a plurality of delayed samples of the input signal via taps (2-1,...,2-N);
orthogonally transforming each of the plurality of delayed input samples;
weighting the plurality of orthogonally-transformed delayed input samples using a first corresponding plurality of orthogonally-transformed adaptive coefficients; and
summing the weighted plurality of orthogonally-transformed delayed input samples along with a feedback signal and outputting a result of the summing as the equalizer output signal,

**characterised in that** the feedback signal is formed by:

creating a plurality of delayed samples of the receiver decision signal via taps (7-1,...,7-N); orthogonally transforming each of the plurality of delayed decision samples;

weighting the plurality of orthogonally-transformed delayed decision samples using a second corresponding plurality of orthogonally-transformed adaptive coefficients; and
summing the weighted plurality of orthogonally-transformed delayed decision samples to create the feedback signal.

2. The method according to claim 1, further comprising updating the second corresponding plurality of orthogonally-transformed adaptive coefficients.

3. The method according to claim 2, wherein the step of updating the second corresponding plurality of orthogonally-transformed adaptive coefficients (v(n)) includes calculating:

$$\mathbf{v}(n) = \mathbf{f}(n)\mathbf{T}_2^{-1T}$$

$$\mathbf{v}(n+1) = \mathbf{v}(n) + \mu_2 e(n)\boldsymbol{\beta}^*(n)$$

$$\boldsymbol{\beta}(n) = \mathbf{b}(n)\mathbf{T}_2$$

in which
$\mu_2$ is an adaptation step size in a transform-domain;

$$e(n) = b(n) - y(n);$$

$b(n)$ is the receiver decision signal;
"*" denotes a complex conjugate;
"T" denotes a transpose operation;
$y(n)$ is the equalizer output signal;
$\mathbf{T}_2$ is an $N$x$N$ orthogonal transform matrix; and
$f(n)$ are feedback filter coefficients.

4. The method according to claim 3, wherein the adaptation step size in the transform domain is calculated as follows:

$$\mu_2 = pN\mu$$

in which
$p$ is an average power of the input signal in a time-domain; and
$\mu$ is an adaptation step size in the time-domain.

5. The method according to claim 2, wherein the step of updating the second corresponding plurality of orthogonally-transformed adaptive coefficients (v(n)) includes calculating:

$$\mathbf{v}(n) = \mathbf{f}(n)\mathbf{T}_2^{-1T}$$

$$\mathbf{v}(n+1) = \mathbf{v}(n) + \mu_2 e(n)\boldsymbol{\beta}^*(n) \cdot / \Gamma_b(n)$$

$$\boldsymbol{\beta}(n) = \mathbf{b}(n)\mathbf{T}_2$$

$$\boldsymbol{\Gamma}_b(n+1) = \lambda\boldsymbol{\Gamma}_b(n) + \left|\boldsymbol{\beta}(n)\right|^2$$

in which
$\boldsymbol{\Gamma}_b(n)$ is a vector containing the average value of the transform of b(n)
$\lambda$ is a positive time constant
$\mu_2$ is an adaptation step size in a transform-domain;

$$e(n) = b(n) - y(n);$$

$b(n)$ is the receiver decision signal;
"*" denotes a complex conjugate;
"T" denotes a transpose operation;
"•/" denotes an element-wise vector division;
"| |$^2$" denotes an element-wise magnitude operation;
$y(n)$ is the equalizer output signal;
$\mathbf{T}_2$ is an $N$x$N$ orthogonal transform matrix; and
$f(n)$ are feed-back filter coefficients.

6. The method according to claim 5, wherein the adaptation step size in the transform domain is calculated as follows:

$$\mu_2 = pN\mu$$

in which
$p$ is an average power of the input signal in a time-domain; and
$\mu$ is an adaptation step size in the time-domain.

7. The method according to claim 1, further comprising updating the first corresponding plurality of orthogonally-transformed adaptive coefficients.

8. The method according to claim 7, wherein the step of updating the first corresponding plurality of orthogonally-transformed adaptive coefficients ($\zeta(n)$) includes calculating:

$$\zeta(n) = \mathbf{c}(n)\mathbf{T}_1^{-1T}$$

$$\zeta(n+1) = \zeta(n) + \mu_1 e(n)\chi^*(n)$$

$$\chi(n) = \mathbf{x}(n)\cdot\mathbf{T}_1$$

in which
$\mu_1$ is an adaptation step size in a transform-domain;

$$e(n) = b(n) - y(n);$$

$b(n)$ is the receiver decision signal;
"*" denotes a complex conjugate;
"T" denotes a transpose operation;
$y(n)$ is the equalizer output signal;
x(n) is the input signal;
$\mathbf{T_1}$ is an $M$x$M$ orthogonal transform matrix; and
$c(n)$ are feed-forward filter coefficients.

9. The method according to claim 8, wherein the adaptation step size in the transform domain is calculated as follows:

$$\mu_1 = pM\mu$$

in which
$p$ is an average power of the input signal in a time-domain; and
$\mu$ is an adaptation step size in the time-domain.

10. The method according to claim 7, wherein the step of updating the first corresponding plurality of orthogonally-transformed adaptive coefficients ($\zeta(n)$) includes calculating:

$$\zeta(n) = \mathbf{c}(n)\mathbf{T}_1^{-1T}$$

$$\zeta(n+1) = \zeta(n) + \mu_1 e(n)\chi^*(n) \cdot / \Gamma_x(n)$$

$$\chi(n) = \mathbf{x}(n) \cdot \mathbf{T}_1$$

$$\Gamma_x(n+1) = \lambda\Gamma_x(n) + |\chi(n)|^2$$

in which
$\Gamma_x(n)$ is a vector containing the average vaules of the transform of x(n)
$\lambda$ is a positive time constant
$\mu$ is an adaptation step size in a time-domain;

$$e(n) = b(n) - y(n);$$

$b(n)$ is the receiver decision signal;
"*" denotes a complex conjugate;
"T" denotes a transpose operation;
"•/" denotes an element-wise vector division;
"| |²" denotes an element-wise magnitude operation;
$y(n)$ is the equalizer output signal;
x(n) is the input signal;
$\mathbf{T_1}$ is an $N$x$N$ orthogonal transform matrix; and
$c(n)$ are feed-forward filter coefficients.

**11.** The method according to claim 10, wherein the adaptation step size in the transform domain is calculated as follows:

$$\mu_1 = pM\mu$$

in which
$p$ is an average power of the input signal in a time-domain; and
$\mu$ is an adaptation step size in the time-domain.

**12.** The method according to claim 1, wherein said orthogonally transforming comprises computing a transform of each of the plurality of delayed input samples in a recursive manner by using a prior orthogonal transform of a prior one of the plurality of delayed input samples in a next orthogonal transform of a next one of the plurality of delayed input samples.

**13.** The method according to claim 12, wherein said computing the transform comprises calculating each ($X(k,n)$) of the plurality of orthogonally-transformed delayed input samples by:

calculating a difference between one of the delayed input samples ($x(n)$) and an $M$th delayed version of said one of the delayed input samples ($x(n-M)$);
adding a $k$th feedback signal to the difference;
multiplying a sum from the adding by a $k$th coefficient;
outputting the multiplied sum as said each ($X(k,n)$) of the plurality of orthogonally-transformed delaying input samples;
delaying the multiplied sum;
feeding back the delayed multiplied sum as the $k$th feedback signal.

**14.** The method according to claim 1, further comprising:

modifying the first corresponding plurality of orthogonally-transformed adaptive coefficients based on decisions made in the receiver using prior versions of an equalizer output signal.

**15.** An apparatus (10) for receiving a digital signal comprising:

a receiver decision device (17) for receiving an equalizer output signal and for supplying a receiver decision signal; and
an adaptive equalizer (20,30) for supplying the equalizer output signal and for receiving the receiver decision signal, said adaptive equalizer (20,30) including a processor (18) to carry out the method of any one of the preceding claims.

**Patentansprüche**

**1.** Verfahren zum Ausführen einer Entzerrung eines Eingangssignals in einem Empfänger, wobei das Verfahren Folgendes umfasst:

Einkoppeln eines Entzerrerausgangssignals in eine Entscheidungsvorrichtung (17) und Empfangen eines Empfängerentscheidungssignals, das von der Entscheidungsvorrichtung (17) zurückkommt,
Erzeugen mehrerer verzögerter Abtastungen des Eingangssignals über Abgriffe (2-1, ..., 2-N),
orthogonales Transformieren jeder der mehreren verzögerten Eingangsabtastungen,
Gewichten der mehreren orthogonal transformierten verzögerten Eingangsabtastungen unter Verwendung erster entsprechender mehrerer orthogonal transformierter adaptiver Koeffizienten, und
Summieren der gewichteten mehreren orthogonal transformierten verzögerter Eingangsabtastungen zusammen mit einem Rückmeldungssignal und Ausgeben eines Ergebnisses der Summierung als das Entzerrerausgangssignal, **dadurch gekennzeichnet, dass** das Rückmeldungssignal gebildet wird durch:

Erzeugen mehrerer verzögerter Abtastungen des Empfängerentscheidungssignals über Abgriffe (7-1, ..., 7-N),

orthogonales Transformieren jeder der mehreren verzögerten Entscheidungsabtastungen,
Gewichten der mehreren orthogonal transformierten verzögerten Entscheidungsabtastungen unter Verwendung zweiter entsprechender mehrerer orthogonal transformierter adaptiver Koeffizienten, und
Summieren der gewichteten mehreren orthogonal transformierten verzögerten Entscheidungsabtastungen zum Erzeugen des Rückmeldungssignals.

2. Verfahren nach Anspruch 1, das des Weiteren das Aktualisieren der zweiten entsprechenden mehreren orthogonal transformierten adaptiven Koeffizienten umfasst.

3. Verfahren nach Anspruch 2, wobei der Schritt des Aktualisierens der zweiten entsprechenden mehreren orthogonal transformierten adaptiven Koeffizienten (v(n)) folgende Berechnungen enthält:

$$v(n) = f(n)T_2^{-1T}$$

$$v(n + 1) = v(n) + \mu_2 e(n)\beta^*(n)$$

$$\beta(n) = b(n)T_2$$

wobei:

$\mu_2$ eine Anpassungsschrittgröße in einem Transformationsbereich ist

$$e(n) = b(n) - y(n)$$

b(n) das Empfängerentscheidungssignal ist
"*" konjugiert-komplex bedeutet
"T" eine Transponierungsoperation bedeutet
y(n) das Entzerrerausgangssignal ist
$T_2$ eine orthogonale Transformationsmatrix von N x N ist und
f(n) Rückmeldungsfilterkoeffizienten sind.

4. Verfahren nach Anspruch 3, wobei die Anpassungsschrittgröße im Transformationsbereich folgendermaßen berechnet wird:

$$\mu_2 = pN\mu$$

wobei p eine durchschnittliche Stärke des Eingangssignals in einem Zeitbereich ist, und $\mu$ eine Anpassungsschrittgröße im Zeitbereich ist.

5. Verfahren nach Anspruch 2, wobei der Schritt des Aktualisierens der zweiten entsprechenden mehreren orthogonal transformierten adaptiven Koeffizienten (v(n)) folgende Berechnungen enthält:

$$v(n) = f(n)T_2^{-1T}$$

$$v(n + 1) = v(n) + \mu_2 e(n)\beta^*(n) \cdot / \Gamma_b(n)$$

$$\beta(n) = b(n)T_2$$

$$\Gamma_b(n + 1) = \lambda\Gamma_b(n) + |\beta(n)|^2$$

wobei
$\Gamma_b(n)$ ein Vektor ist, der den Durchschnittswert der Transformation von b(n) enthält
$\lambda$ eine positive Zeitkonstante ist
$\mu_2$ eine Anpassungsschrittgröße in einem Transformationsbereich ist

$$e(n) = b(n) - y(n)$$

b(n) das Empfängerentscheidungssignal ist
"*" konjugiert-komplex bedeutet
"$^T$" eine Transponierungsoperation bedeutet
"·/" eine elementweise Vektorteilung bedeutet
"| |$^2$" eine elementweise Größenordnungsoperation bedeutet
y(n) das Entzerrerausgangssignal ist
$T_2$ eine orthogonale Transformationsmatrix von N x N ist und
f(n) Rückmeldungsfilterkoeffizienten sind.

6. Verfahren nach Anspruch 5, wobei die Anpassungsschrittgröße in dem Transformationsbereich folgendermaßen berechnet wird:

$$\mu_2 = pN\mu$$

wobei
p eine durchschnittliche Stärke des Eingangssignals in einem Zeitbereich ist und
$\mu$ eine Anpassungsschrittgröße in dem Zeitbereich ist.

7. Verfahren nach Anspruch 1, das des Weiteren das Aktualisieren der ersten entsprechenden mehreren orthogonal transformierten adaptiven Koeffizienten umfasst.

8. Verfahren nach Anspruch 7, wobei der Schritt des Aktualisierens der ersten entsprechenden mehreren orthogonal transformierten adaptiven Koeffizienten ($\zeta(n)$) folgende Berechnungen umfasst:

$$\zeta(n) = c(n)T_1^{-1T}$$

$$\zeta(n + 1) = \zeta(n) + \mu_1 e(n)X^*(n)$$

$$X(n) = x(n)·T_1$$

wobei
$\mu_1$ eine Anpassungsschrittgröße in einem Transformationsbereich ist

$$e(n) = b(n) - y(n)$$

b(n) das Empfängerentscheidungssignal ist

"*" konjugiert-komplex bedeutet

"$^T$" eine Transponierungsoperation bedeutet

y(n) das Entzerrerausgangssignal ist

x(n) das Eingangssignal ist

$T_1$ eine orthogonale Transformationsmatrix von M x M ist und

c(n) Vorwärtskopplungsfilterkoeffizienten sind.

9. Verfahren nach Anspruch 8, wobei die Anpassungsschrittgröße in dem Transformationsbereich folgendermaßen berechnet wird:

$$\mu_1 = pM\mu$$

wobei

p eine durchschnittliche Stärke des Eingangssignals in einem Zeitbereich ist und

$\mu$ eine Anpassungsschrittgröße in dem Zeitbereich ist.

10. Verfahren nach Anspruch 7, wobei der Schritt des Aktualisierens der ersten entsprechenden mehreren orthogonal transformierten adaptiven Koeffizienten ($\zeta(n)$) folgende Berechnungen enthält:

$$\zeta(n) = c(n)T_1^{-1T}$$

$$\zeta(n + 1) = \zeta(n) + \mu_1 e(n)X^*(n) \cdot/ \Gamma_x(n)$$

$$X(n) = x(n)\cdot T_1$$

$$\Gamma_x(n + 1) = \lambda\Gamma_x(n) + |X(n)|^2$$

wobei

$\Gamma_x(n)$ ein Vektor ist, der die Durchschnittswerte der Transformation von x(n) enthält

$\lambda$ eine positive Zeitkonstante ist

$\mu$ eine Anpassungsschrittgröße in einem Zeitbereich ist

$$e(n) = b(n) - y(n)$$

b(n) das Empfängerentscheidungssignal ist

"*" konjugiert-komplex bedeutet

"$^T$" eine Transponierungsoperation bedeutet

"$\cdot/$" eine elementweise Vektorteilung bedeutet

"$| |^2$" eine elementweise Größenordnungsoperation bedeutet

y(n) das Entzerrerausgangssignal ist

x(n) das Eingangssignal ist

$T_1$ eine orthogonale Transformationsmatrix von N x N ist und

c(n) Vorwärtskopplungsfilterkoeffizienten sind.

11. Verfahren nach Anspruch 10, wobei die Anpassungsschrittgröße in dem Transformationsbereich folgendermaßen berechnet wird:

$$\mu_1 = pM\mu$$

wobei

p eine durchschnittliche Stärke des Eingangssignals in einem Zeitbereich ist und

μ eine Anpassungsschrittgröße in dem Zeitbereich ist.

**12.** Verfahren nach Anspruch 1, wobei das orthogonale Transformieren das Berechnen einer Transformation jeder der mehreren verzögerten Eingangsabtastungen in einer rekursiven Weise durch Verwenden einer vorherigen orthogonalen Transformation einer vorherigen der mehreren verzögerten Eingangsabtastungen in einer nächsten orthogonalen Transformation einer nächsten der mehreren verzögerten Eingangsabtastungen umfasst.

**13.** Verfahren nach Anspruch 12, wobei das Berechnen der Transformation Folgendes umfasst: Berechnen jedes (X(k,n)) der mehreren orthogonal transformierten verzögerten Eingangsabtastungen durch:

Berechnen einer Differenz zwischen einer der verzögerten Eingangsabtastungen (x(n)) und einer M-ten verzögerten Version der einen der verzögerten Eingangsabtastungen (x(n - M)),
Addieren eines k-ten Rückmeldungssignals zu der Differenz,
Multiplizieren einer aus der Addierung hervorgegangenen Summe mit einem k-ten Koeffizienten,
Ausgeben der multiplizierten Summe als jedes (X(k,n)) der mehreren orthogonal transformierten verzögernden Eingangsabtastungen,
Verzögern der multiplizierten Summe,
Rückmelden der verzögerten multiplizierten Summe als das k-te Rückmeldungssignal.

**14.** Verfahren nach Anspruch 1, das des Weiteren umfasst:

Modifizieren der ersten entsprechenden mehreren orthogonal transformierten adaptiven Koeffizienten auf der Grundlage von Entscheidungen, die von dem Empfänger unter Verwendung früherer Versionen eines Entzerrerausgangssignals getroffen wurden.

**15.** Vorrichtung (10) zum Empfangen eines digitalen Signals, umfassend:

eine Empfängerentscheidungsvorrichtung (17) zum Empfangen eines Entzerrerausgangssignals und zum Ausgeben eines Empfängerentscheidungssignals, und
einen adaptiven Entzerrer (20, 30) zum Ausgeben des Entzerrerausgangssignals und zum Empfangen des Empfängerentscheidungssignals, wobei der adaptive Entzerrer (20, 30) einen Prozessor (18) enthält, um das Verfahren eines der vorangehenden Ansprüche auszuführen.

**Revendications**

**1.** Procédé pour exécuter une égalisation sur un signal d'entrée dans un récepteur, le procédé comprenant les étapes consistant à:

coupler un signal de sortie d'égaliseur à un dispositif de décision (17) et à recevoir un signal de décision d'un récepteur en retour du dispositif de décision (17);
créer une pluralité d'échantillons retardés du signal d'entrée par le biais de branchements (2-1,...,2-N);
transformer orthogonalement chacun de la pluralité d'échantillons d'entrée retardés; pondérer la pluralité d'échantillons d'entrée retardés orthogonalement transformés en utilisant une première pluralité correspondante de coefficients adaptatifs orthogonalement transformés; et
additionner la pluralité pondérée d'échantillons d'entrée orthogonalement transformés avec un signal de rétroaction et à produire un résultat de la sommation en tant que signal de sortie de l'égaliseur, **caractérisé en ce que** le signal de rétroaction est formé par les étapes consistant à:

créer une pluralité d'échantillons retardés du signal de décision de récepteur par le biais de branchements (7-1,...7-N);
transformer orthogonalement chacun de la pluralité d'échantillons de décision retardés; pondérer la pluralité d'échantillons de décision retardés orthogonalement transformés en utilisant une seconde pluralité correspondante de coefficients adaptatifs orthogonalement transformés; et
additionner la pluralité pondérée d'échantillons de décision retardés orthogonalement transformés de manière à créer le signal de rétroaction.

**2.** Procédé selon la revendication 1, comprenant encore la mise à jour de la seconde pluralité correspondante de coefficients adaptatifs orthogonalement transformés.

**3.** Procédé selon la revendication 2, dans lequel l'étape consistant à mettre à jour la seconde pluralité correspondante de coefficients adaptatifs orthogonalement transformés ($v(n)$) comprend le calcul:

$$v(n) = f(n)T_2^{-IT}$$

$$v(n + 1) = v(n) + \mu_2 e(n)\beta^*(n)$$

$$\beta(n) = b(n)T_2$$

où
$\mu_2$ est une taille d'étape d'adaptation dans un domaine de transformation;

$$e(n) = b(n) - y(n);$$

$b(n)$ est le signal de décision de récepteur;
"*" indique un conjugué complexe;
"$T$" indique une opération de transposition;
$y(n)$ est le signal de sortie d'égaliseur;
$T_2$ est une matrice de transformation orthogonale NxN; et
$f(n)$ sont des coefficients de filtre de rétroaction.

**4.** Procédé selon la revendication 3, dans lequel la taille d'étape d'adaptation dans le domaine de transformation est calculée comme suit:

$$\mu_2 = pN\mu$$

où
$p$ est une puissance moyenne du signal d'entrée dans un domaine de temps; et
$\mu$ est une taille d'étape d'adaptation dans le domaine de temps.

**5.** Procédé selon la revendication 2, dans lequel l'étape consistant à mettre à jour la seconde pluralité correspondante de coefficients adaptatifs orthogonalement transformés ($v(n)$) comprend le calcul:

$$v(n) = f(n)T_2^{-IT}$$

$$v(n + 1) = v(n) + \mu_2 e(n)\beta^*(n) \cdot / \Gamma_b(n)$$

$$\beta(n) = b(n)T_2$$

$$\Gamma_b(n+1) = \lambda\Gamma_b(n) + \left|\beta(n)\right|^2$$

où
$\Gamma_b(n)$ est un vecteur contenant la valeur moyenne de la transformation de b(n);
$\lambda$ est une constante de temps positive;
$\mu_2$ est une taille d'étape d'adaptation dans un domaine de transformation;

$$e(n) = b(n) - y(n);$$

b(n) est le signal de décision de récepteur;
"*" indique un conjugué complexe;
"$^T$" indique une opération de transposition;
". /" indique une division de secteur en forme d'élément;
"$||^2$" indique une opération de grandeur en forme d'élément;
y(n) est le signal de sortie d'égaliseur;
**$T_2$** est une matrice de transformation orthogonale NxN; et
f(n) sont des coefficients de filtre de rétroaction.

6. Procédé selon la revendication 5, dans lequel la taille d'étape d'adaptation dans le domaine de transformation est calculée comme suit:

$$\mu_2 = pN\mu$$

où p est une puissance moyenne du signal d'entrée dans un domaine de temps; et
$\mu$ est une taille d'étape d'adaptation dans le domaine de temps.

7. Procédé selon la revendication 1, comprenant encore l'étape consistant à mettre à jour la première pluralité correspondante de coefficients adaptatifs orthogonalement transformés.

8. Procédé selon la revendication 7, dans lequel l'étape consistant à mettre à jour la première pluralité correspondante de coefficients adaptatifs orthogonalement transformés ($\zeta(n)$) comprend le calcul:

$$\zeta(n) = c(n)T_1^{-1T}$$

$$\zeta(n+1) = \zeta(n) + \mu_1 e(n)\chi^*(n)$$

$$\chi(n) = x(n) \cdot T_1$$

où
$\mu_1$ est une taille d'étape d'adaptation dans un domaine de transformation;

$$e(n) = b(n) - y(n);$$

b(n) est le signal de décision de récepteur;

"*" indique un conjugué complexe;

"$^T$" indique une opération de transposition;

y(n) est le signal de sortie d'égaliseur;

x(n) est le signal d'entrée;

$\mathbf{T_1}$ est une matrice de transformation orthogonale MxM; et

c(n) sont des coefficients de filtre à réaction en avant.

9.  Procédé selon la revendication 8, dans lequel la taille d'étape d'adaptation dans le domaine de transformation est calculée comme suit:

$$\mu_1 = pM\mu$$

où

p est une puissance moyenne du signal d'entrée dans un domaine de temps; et

$\mu$ est une taille d'étape d'adaptation dans le domaine de temps.

10.  Procédé selon la revendication 7, dans lequel l'étape consistant à mettre à jour la première pluralité correspondante de coefficients adaptatifs orthogonalement transformés ($\zeta$(n)) comprend le calcul:

$$\zeta(n) = \mathbf{c}(n)\mathbf{T}_1^{-1T}$$

$$\zeta(n + 1) = \zeta(n) + \mu_1 e(n)\chi^*(n)\cdot / \Gamma_x(n)$$

$$\chi(n) = \mathbf{x}(n) \cdot \mathbf{T}_1$$

$$\Gamma_x(n + 1) = \lambda\Gamma_x(n) + |\chi(n)|^2$$

où

$\Gamma_x(n)$ est un vecteur contenant les valeurs moyennes de la transformation de x(n);

$\lambda$ est une constante de temps positive;

$\mu$ est une taille d'étape d'adaptation dans un domaine de transformation;

$$e(n) = b(n) - y(n);$$

b(n) est le signal de décision de récepteur;

"*" indique un conjugué complexe;

"$^T$" indique une opération de transposition;

". /" indique une division de secteur en forme d'élément;

"$| |^2$" indique une opération de grandeur en forme d'élément;

y(n) est le signal de sortie d'égaliseur;

x(n) est le signal d'entrée;

$\mathbf{T_1}$ est une matrice de transformation orthogonale NxN; et

c(n) sont des coefficients de filtre à réaction en avant.

11.  Procédé selon la revendication 10, dans lequel la taille d'étape d'adaptation dans le domaine de transformation est calculée comme suit:

$$\mu_1 = pM\mu$$

où

p est une puissance moyenne du signal d'entrée dans un domaine de temps; et

$\mu$ est une taille d'étape d'adaptation dans le domaine de temps.

12. Procédé selon la revendication 1, dans lequel ladite transformation orthogonale comprend l'étape consistant à calculer d'une manière récursive une transformation de chacun de la pluralité d'échantillons d'entrée retardés par l'utilisation d'une transformation orthogonale précédente d'un échantillon d'entrée retardé précédent de la pluralité d'échantillons d'entrée retardés dans une transformation orthogonale suivante d'un échantillon d'entrée retardé suivant de la pluralité d'échantillons d'entrée retardés.

13. Procédé selon la revendication 12, dans lequel ledit calcul de la transformation comprend le calcul de chacun (X(k, n)) de la pluralité d'échantillons d'entrée retardés orthogonalement transformés par des étapes consistant à:

calculer une différence entre un des échantillons d'entrée retardés (x(n)) et une version retardée Mth dudit un des échantillons d'entrée retardés (x(n-M));

ajouter un signal de rétroaction kth à la différence;

multiplier une somme de l'addition par un coefficient kth;

fournir la somme multipliée comme ledit chacun (X(k,n)) de la pluralité d'échantillons d'entrée retardés orthogonalement transformés;

retarder la somme multipliée;

réappliquer la somme multipliée retardée en tant que signal de rétroaction kth.

14. Procédé selon la revendication 1, comprenant encore l'étape consistant à:

modifier la première pluralité correspondante de coefficients adaptatifs orthogonalement transformés sur la base de décisions qui sont faites dans le récepteur en utilisant des versions antérieures d'un signal de sortie d'égaliseur.

15. Appareil (10) pour recevoir un signal numérique comprenant:

un dispositif de décision de récepteur (17) pour recevoir un signal de sortie d'égaliseur et pour fournir un signal de décision de récepteur; et

un égaliseur adaptatif (20, 30) pour fournir le signal de sortie d'égaliseur et pour recevoir le signal de décision de récepteur, ledit égaliseur adaptatif (20, 30) comprenant un processeur (18) pour mettre en oeuvre le procédé selon l'une quelconque des revendications précédentes 1 à 14.

<u>10</u>

FIG. 1

FIG. 2

FIG. 3

FIG. 4

PERFORMANCE FOR CHANNEL 1

FIG. 5